# EUROPEAN PATENT SPECIFICATION

(11) **EP 0 997 953 B1**
(45) Date of publication and mention of the grant of the patent: **14.01.2004**
(21) Application number: 99203868.7
(22) Date of filing: 11.07.1996
(51) Int. Cl.: H01L 41/12

(54) **An actuator for producing motion and force by controlling the twin structure orientation of an actuator material**
Antrieb zum Erzeugen von Bewegung und Kraft durch Kontrolle der Doppelstruktur eines Materials
Organe d'actionnement pour la production de mouvement et de force par commande de l'orientation de la structure jumelée d'un matériau

(30) Priority: 11.07.1995 FI 953394
(43) Date of publication of application: 03.05.2000
(62) Divisional of application: 96922915.2
(73) Proprietor: Adaptive Materials Technology Oy, 00390 Helsinki (FI)
(72) Inventor: Ullakko, Kari Martti, 02270 Espoo (FI)
(74) Representative: Laitinen, Pauli Sakari

(56) References cited:
- DATABASE WPI Section Ch, Week 199146 Derwent Publications Ltd., London, GB; Class L03, AN 1991-337460 XP002137423 & SU 1 611 980 A (AS UKR METAL-PHYS), 7 December 1990 (1990-12-07)
- KAKESHITA T ET AL: "MAGNETOELASTIC MARTENSITIC TRANSFORMATION IN AN AUSAGED FE-NI-CO-TIALLOY" SCRIPTA METALLURGICA,GB,ELSEVIER SCIENCE LTD., KIDLINGTON, vol. 19, 1 August 1985 (1985-08-01), pages 973-976, XP000609308 ISSN: 0036-9748
- ULLAKKO K: "MAGNETICALLY CONTROLLED SHAPE MEMORY ALLOYS: A NEW CLASS OF ACTUATOR MATERIALS" JOURNAL OF MATERIALS ENGINEERING AND PERFORMANCE,US,ASM INTERNATIONAL, MATERIALS PARK, vol. 5, no. 3, 1 June 1996 (1996-06-01), pages 405-409, XP000593943 ISSN: 1059-9495

## Description

### FIELD OF THE INVENTION

The present invention relates to an actuator in which an actuating element is made of a material whose twin structure is reoriented by an applied magnetic field. The magnetic-field-induced reorientation of the twin structure produces shape changes of the actuating element, resulting in a motion and force output of the actuator.

### BACKGROUND OF THE INVENTION

Control of motion and force is one of the basic elements in mechanical engineering. Development of new materials has made it possible to produce motion and force using special functional materials called actuator materials. Those materials are used in actuating elements in actuators. The most important groups of actuator materials available are piezoelectric ceramics, magnetostrictive intermetallics, and shape memory alloys. Piezoelectric ceramics develop strains when subjected to an electric field. Frequency response of these materials is fast, but the strain amplitudes are very small, which limits their applicability. Magnetostrictive materials are strained when a magnetic field is imposed on them. Certain high-magnetostrictive intermetallics (e.g., Terfenol-D, Etrema Products, Inc., Ames, IA, USA) offer strains up to 0.17 %, which is an order of magnitude higher than those of the current piezolectrics. The frequency response of the magnetostrictive intermetallics is lower than that of the piezoelectrics.

Shape memory metals are materials which, when plastically deformed at one temperature, can recover their original undeformed state upon raising their temperature above an alloy-specific transformation temperature. In these materials, crystal structure undergoes a phase transformation into, and out of, a martensite phase when subjected to mechanical loads or temperature. The process when a mechanically deformed shape memory material returns to its original form after heating is called a one-way shape memory effect. Cooling the material subsequently will not reverse the shape change. The one-way shape memory effect is utilized in fastening, tightening and prestressing devices. Strains of several percent can be completely recovered, and recovery stresses of over 900 MPa have been attained. In the case of the two-way effect, no deformation is required, and the material "remembers" two configurations that are obtained by heating and cooling to alloy-specific temperatures. The temperature difference between the two configurations can be as small as 1 to 2 K. Materials that exhibit a two-way shape memory effect are used to develop forces and displacements in actuators. Those actuators are applied in machinery, robotics and biomedical engineering. The most extensively used shape memory materials are Ni-Ti and Cu-based alloys. A drawback of the shape memory actuators is their slow response due to the thermal control (especially in cooling) and low efficiency (energy conversion), which in many alloys is only about one percent.

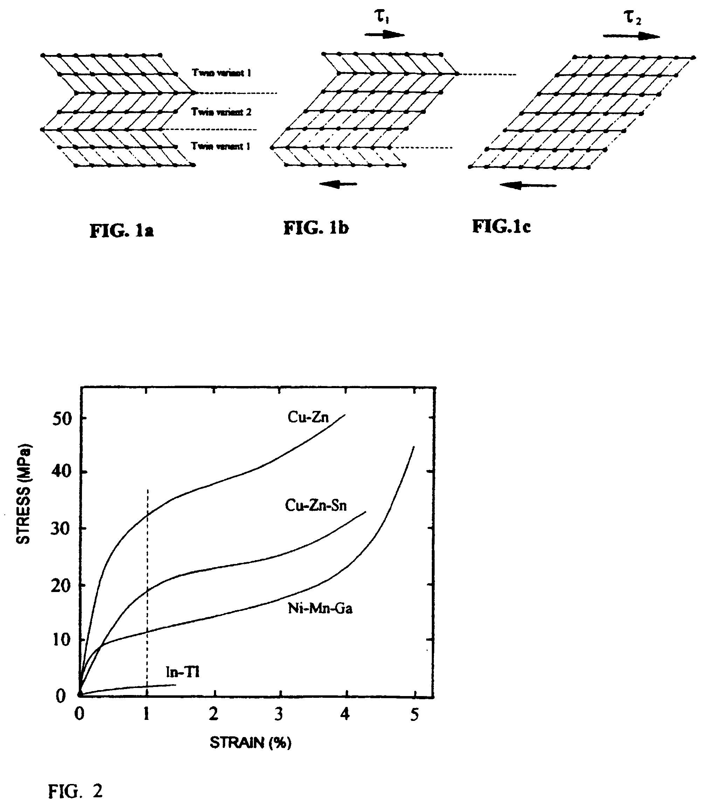

In order for the shape memory effect to occur, the material must exhibit a twinned substructure. The shape change of the shape memory material is based on the reorientation of the twin structure in the external stress field. A two-dimensional illustration of the twin reorientation is presented in Figure 1. Figure 1 (a) shows two twin variants, denoted by 1 and 2, with equal proportions in the absence of the external stress. When the stress is applied, Figure 1(b), the twin boundaries move and variant 2 grows at the expense of variant 1, producing the shape which better accommodates the applied stress. The result of moving a twin boundary is thus to convert one twin variant into another. The variants which are most favorably oriented to the applied stress will grow. Ultimately, a single variant of martensite can be produced by straining a sufficient amount, as illustrated in Figure 1(c). In the martensite phase, the variants are usually oriented in several crystallographic directions. Therefore, complex shape changes of the material can be produced by the reorientation of the twin structure, and a full shape recovery will be obtained. Crystallographic analysis has shown that the boundaries between the martensite plates also behave as twin boundaries, i.e., the individual plates of martensite themselves are twins with respect to adjoining plates. Thus the term "twin boundaries", generally refers to the boundaries between martensite plates as well as the boundaries between the boundaries within the plates (this definition also concerns the magnetically controlled twin boundaries discussed below). In some materials, applied stress induces formation of the martensite phase whose twinned substructure is preferentially oriented according to the applied stress.

Reorientation of the twin structure is responsible for the recoverable strains of several percent in appropriate materials (e.g., close to 10 percent in Ni-Ti shape memory alloys). In some alloys the stress required to reorient the twin structure is very low. Figure 2 shows the stress-strain curves for the selected shape memory materials.

It is seen that strains of 4 percent are attained by stresses of 20 to 50 MPa in most of those alloys. Stresses as low as 1 to 30 MPa result in strains of one percent. Strain energy densities needed to produce the strain of 1 percent by the reorientation of the twin variants are the areas restricted by the stress-strain curves, strain axis and the vertical dashed line in Figure 2. The strain energy densities for the alloys In-TI, Ni-Mn-Ga (ferromagnetic Ni₂MnGa), Cu-Zn-Sn and Cu-Zn are 10⁴, 8.5 x 10⁴, 1.1 x 10⁵ and 2.3 x 10⁵ J/m³, respectively.

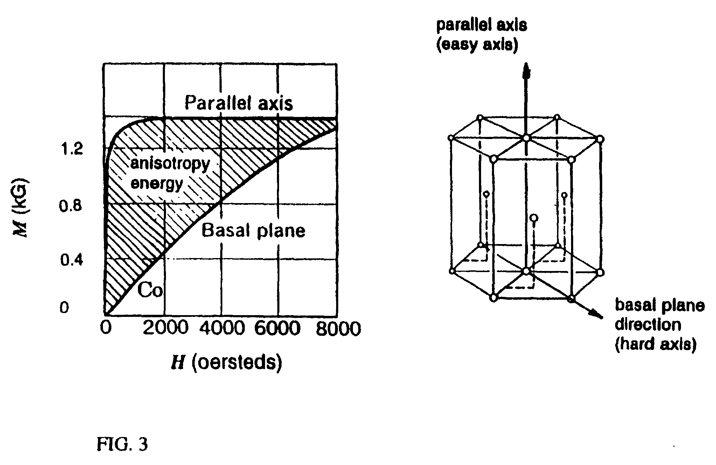

In the following, magnetic anisotropy energy is introduced, because it plays an important role in the present invention. In ferromagnetic crystals magnetocrystalline anisotropy energy is an energy which directs the magnetization along certain definite crystallographic axes called directions of easy magnetization. Figure 3 shows the magnetization curves of single crystalline cobalt which has a hexagonal crystal structure. Its easy direction of magnetization is the parallel axis of the unit cell. The saturation is reached at a low magnetic field value in this direction, as shown in Figure 3. Saturating the sample in the basal plane is much more difficult. A magnetic field over 8000 Oe (1 Oe = 89.577 A/m) is needed for saturation. The basal plane direction is called a hard direction of magnetization. Magnetic anisotropy energy density corresponding to the magnetization processes in different directions is the area between the magnetization curves for those directions. In cobalt the energy density needed to saturate the sample in the hard direction is about 5 x 10⁵ J/m³ (the area between the saturation curves in Figure 3). Anisotropy energy densities of magnetically hard Fe- and Co-based alloys range from 10⁵ up to 10⁷ J/m³. The highest anisotropy energy densities (K1 values), close to 10⁸ J/m³, are in 4f metals at low temperatures. In intermetallic compounds such as Co₅Nd₁ Fe₁₄Nd₂B and Sm₂Co₁₇ the anisotropy energy densities at room temperature are 1. 5 x 10⁷, 5 x 10⁷ and 3.2 x 10⁶ J/m³, respectively.

Each of documents DATABASE WPI Section Ch, Week 199146 Derwent Publications Ltd., London, GB; Class L03, AN 1991-337460 & SU 1 611 980 A (AS UKR METAL-PHYS), 7 December 1990 (1990-12-07) and KAKESHITA T ET AL: 'MAGNETOELASTIC MARTENSITIC TRANSFORMATION IN AN AUSAGED FE-NI-CO-TIALLOY' SCRIPTA METALLURGICA,GB, ELSEVIER SCIENCE LTD., KIDLINGTON, vol. 19, 1 August 1985 (1985-08-01), pages 973-976, discloses alloys which can perform reversible magnetoelastic martensitic transformations.

### SUMMARY OF THE INVENTION

This invention concerns an operational principle of the magnetically driven actuators that produce motion and force. The operation is based on the magnetic-field-controlled reorientation of the twin structure of the actuator material. These kinds of actuators can produce strains of several percent (as large as the shape memory materials produce). Because of the magnetic control of the new actuators, the response times are much faster, control more precise, and efficiency better than those of the shape memory materials. The new magnetically driven actuators will exhibit a great potential in mechanical engineering. They will replace hydraulic, pneumatic and electromagnetic drives in many applications. Employment of these actuators leads to simpler, lighter, and more reliable constructions than use of conventional technology. Because the twin reorientation occurs in three dimensions, complex magnetic-field-induced shape changes of the actuating elements can be produced. Applicability of this invention is expanded by the possibility for controlling and supplying the power of the actuators at a distance. The machine developing a controlled motion or desired shape changes (e.g., bending, shearing, twisting, clipping, fastening, pumping fluids) may be a small appropriately shaped and preoriented piece of actuator material. Due to the small twin size in many materials, this invention is expected to have great potential also in micro- and nanotechnology.

In consequence, the invention consists of an actuator that produces motion and/or force based on a material in which the magnetic field induces shape changes by controlling the orientation of the twin structure according to claim 1.

### BRIEF DESCRIPTION OF THE DRAWINGS

Figures 1(a) to 1(c) show a schematic (two dimensional) presentation of the shape change in martensite material as described above, namely turning of the twin variants by stress.
Figure 2 shows stress-strain (tensile) curves for single crystalline alloys In-TI, Cu-Zn-Sn and a Ni-Mn-Ga Heusler-alloy (Ni₂MnGa) and for a polycrystalline Cu-Zn shape memory alloy during the reorientation of the twin structure.
Figure 3 presents magnetization curves of single crystalline cobalt.
Figure 4 shows the principle of the present invention, namely turning of the twin variants by the external magnetic field.
Figure 4(a) presents the starting situation in the absence of the external magnetic field;
Figure 4(b) shows the turning of the twin variant by the applied magnetic field H.
Figures 5(a) to 5(c) show the principle of the magnetic field-induced shape change of the twinned material which results in the shape change of the material) and the motion and force of the actuator, namely;
Figure 5(a) presents the starting situation in the absence of the external magnetic field;

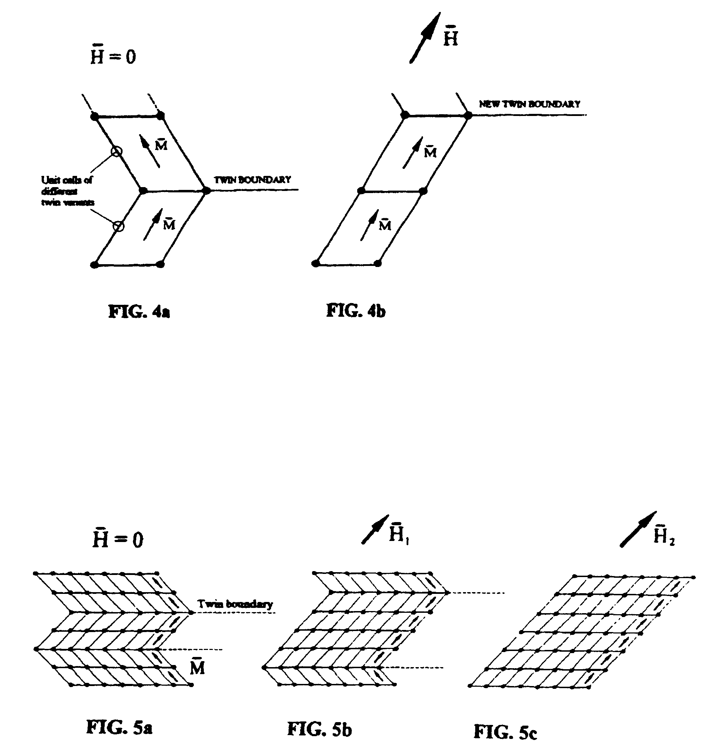

Figure 5(b) shows the step where the external magnetic field H₁ acts on the material;
Figure 5(c) presents the ultimate situation after the complete reorientation of the twin structure by the magnetic field.

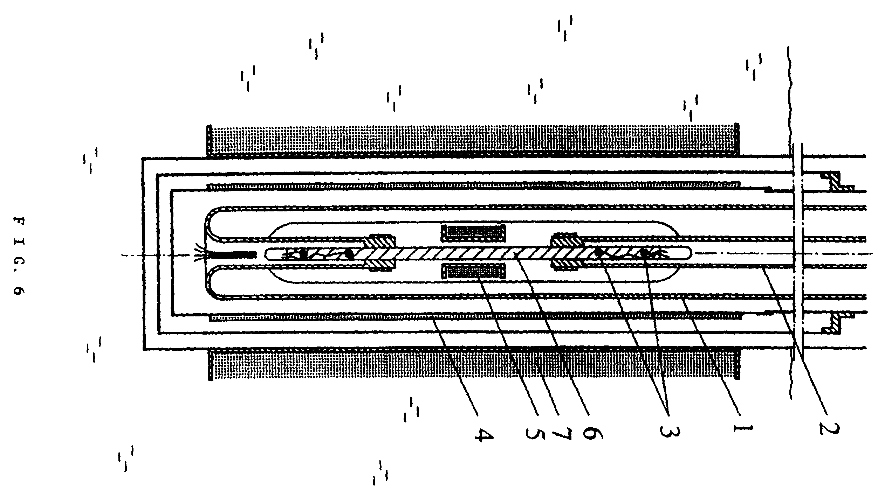

Figure 6 shows the actuator setup for studying the reorientation of the twin structure of the actuating element by the magnetic field.

### DETAILED DESCRIPTION OF THE INVENTION

This invention is an actuator for producing shape changes, motion and/or force based on the reorientation of the unit cells of the material of the actuating element having a twinned structure by the applied magnetic field, which results in the change of the proportions of the twin variants, e.g., motion of twin boundaries. In this invention, the term "twin boundaries" refers to the boundaries between martensite plates as well as the boundaries between the boundaries within the plates. This invention also concerns change of the dimensions of the martensite plates whose twinned substructure is preferentially oriented according to the applied magnetic field. Change of the proportions of twin variants by the applied magnetic field according to the invention includes both the reorientation of the twin variants in one phase as well as change of the proportions of twin variants in the martensite plates whose dimensions change due to the applied magnetic field.

The present invention is described on the following pages by explaining the relevant properties of the present invention and by referring to some figures describing the background for easier understanding of the present invention. Reference is made to all figures 2 to 6.

Figure 4 shows a two-dimensional illustration of the principle of the reorientation of the twin structure by the applied magnetic field. In crystalline ferromagnetic materials, magnetization vectors lie along directions of easy magnetization in the absence of the external magnetic field. This situation is shown in Figure 4(a) for two twin variants. The easy direction of magnetization is parallel with the side of the unit cells of each variant. It is emphasized that the easy direction is not necessarily parallel with the side of the unit cell but it can also be any other crystallographic direction characteristic of the material.

When an external magnetic field is applied on a crystalline ferromagnetic material, the magnetization vectors tend to turn from the easy direction of the unit cell to the direction of the external magnetic field. If the magnetocrystalline anisotropy energy, denoted by Uₖ in this presentation, is high, the magnetic field strengths required to turn the magnetization off from the easy directions are also high. This was illustrated for hexagonal cobalt in Figure 3. If the energy of turning the twin variants, (i.e., the energy of the motion of the twin boundaries) is low enough compared to the magnetocrystalline anisotropy energy Uₖ, the twin variants are turned by the external magnetic field, and the magnetization remains in the original easy direction of the turned unit cells. Figure 4(b) shows how the unit cells of one variant are turned into another by the external magnetic field. As a result, twins in favorable orientation to the magnetic field grow at the expense of the other twins, as shown in Figure 5.

Figure 5(a) represents the starting situation in the absence of the field when the twin variants with equal proportions are present. Magnetization is aligned parallel to one side of the unit cell in each variant. In the figure, only a part of the magnetization vectors is shown. In this illustration twins are assumed to be consisted of only single ferromagnetic domains (recent TEM studies have revealed that twins in some ferromagnetic martensites, e.g., Fe-Pt can be consisted of two magnetic domains whose domain wall crosses the twin).

Figure 5(b) shows how the unit cells whose easy direction of magnetization are different from the direction of the external magnetic field are turned so as to line up with the field direction. This results in the growth of the favorably oriented twin variant and the decrease of the other variant. Ultimately, only one twin variant may remain, as shown in Figure 5(c). Magnetic-field-induced shape changes based on the reorientation of the twin structure do not require phase changes to occur.

The reorientation of the twin structure described above results in the shape change of the material, which can produce motion and force in the magnetically controlled actuators based on this material. The magnetic field is applied on the material in such a direction and magnitude that it induces a desired shape change or motion of the actuator material. Direction of the applied magnetic field can also be other than the easy direction of the magnetization of the twin variants. It is possible also to produce complex shape changes because the reorientation of the twin structure occurs in three dimensions. The proportions of different twin variants and, hence, the shape change of the actuating element can also be affected by mechanical load or prestress. The original dimensions of the actuator material may be restored by turning the field to another direction, or by loading the actuator material, or by eliminating the field. Effects of the external magnetic field on the orientation of the martensite unit cells can cause the directed motion of martensite-martensite and austenite-martensite interfaces, which may also be utilized in actuators. In the latter case the preferentially oriented twinned martensite grows at the expense of the parent phase. This growth can also be reversible.

The actuator may be composed of an actuating element or several elements that produce(s) motion and/or force by the magnetic field induced by a magnetic field source or many sources. Each of the magnetic field sources can be, e.g., an electromagnet, or a coil, or a permanent magnet. Those field sources are placed in such a way that the static or alternating magnetic fields induced by them produce (a) desired shape change(s) of the actuating element(s). The magnetic field source(s) may also be remote from the actuator. The directions and/or magnitudes of the fields generated by the magnetic field source(s) may be different and they can vary in time. The actuator can include one or more prestressing devices, e.g., springs that load the actuating element(s) in an appropriate direction(s) and strength(s). The actuating element is made of an actuator material in which the magnetic field causes the reorientation of the unit cells and changes the proportions of different twin variants, which affects the motion of the twin boundaries. Actuating element may be a piece of an actuator material consisted of one or more variants that form bands through the element, as illustrated in Fig. 5. Figure 5 shows an example in which the magnetic-field-induced shape change of the actuating element is shear-type. The shape change of the element can also be, e.g., axial strain (extension or contraction), bending or torsion, or the element may be consisted of such a microstructure that the shape change in one part of the element is different than in the other part. The actuating element can be composed of the martensitic plates in the parent phase (austenite) matrix. The magnetic-field-induced shape change of such an element is caused by the motion of boundaries between martensite plates, and/or by the motion of the twin boundaries within the plates, as well as by the change of the dimensions of the martensite plates whose twinned substructure is preferentially oriented according to the applied magnetic field.

Figure 6 shows an example of an actuator in which magnetic field source is a coil (7) that induces a static or alternating magnetic field whose direction is substantially parallel to the direction of the long dimension of actuating element (6). The magnetic-field-induced shape change of the element may be, e.g., axial strain, bending or twisting. The direction of the magnetic field in Fig. 6 is also the loading direction of the actuating element when loaded axially, and the torsion axis when magnetic-field-induced twisting shape change of the actuating element is produced. Pick-up coil (5) measures magnetic susceptibility of the actuating element when low alternating magnetic field component is induced using coil 7. Loading the actuating element, e.g., by straining axially or by torsion using bar 2, proportions of the twin variants change which causes a change in the signal detected by pick-up coil 5. The measuring arrangement shown here is an example how the state of a shape of the actuating element produced by mechanical loading or by applying a magnetic field can be monitored remote from the element. The actuating element may also be used for sensoring purposes.

The magnetic field can be applied in such a direction in relation to the actuating element that it produces a desired shape change of the element. One example is to place a magnetic field source in such a way that the direction of the magnetic field that it induces is perpendicular to the direction of the long dimension of the actuating element. The actuating element may strain axially or by shearing, bending or twisting in the applied magnetic field. The direction of the long dimension of the element can be the straining axis and the direction of the external load. The load can restore the shape change that is induced by the magnetic field. Perpendicular magnetic fields generated by two magnetic field sources, e.g., coils or electromagnets can be used to change the direction and magnitude of the magnetic field, e.g., rotation of the field, in relation to the actuating element. One of the field sources may also induce a static field. When the magnetic fields of one or both of the field sources are periodically changed, the shape of the actuating element is also periodically changed. Two magnetic field sources may synchronously generate magnetic field components also in such a way that the resulting magnetic field rotates in relation to the actuating element. One embodiment of an actuator consists of an actuating element in which one dimension is long as compared to another, and one of the magnetic field sources is placed in such a way that the magnetic field induced by it is in the direction parallel to the long dimension of the actuating element and the other is perpendicular to it.

The magnetic-field-control of the reorientation of the twin variants is expected to produce recoverable strains of several percent in appropriate materials (analogous to stress-induced recoverable strains in the shape memory alloys). To reach a certain magnetically induced strain, it is necessary that the magnetocrystalline anisotropy energy Uₖ of the material is larger than or comparable to the energy needed to reorient the twin variants to achieve this strain. The latter energy, defined as the energy of the reorientation of the twin structure, and denoted by E_{tw}, includes also strain and dissipation energy terms related to the shape change of the material. In the actuator applications, Uₖ must be greater than the sum of E_{tw} and the work of the actuator. The work term may be positive or negative. If the work is negative, the external stress may assist the reorientation of the twin structure and decrease the magnetic field energy required. For the actuator to be able to operate, it is necessary that the magnetic field energy that controls the actuator must be larger than the sum of E_{tw} and the work of the actuator. The higher the Uₖ is, the larger the magnetic field energies are which can be converted to mechanical work of the actuators and, hence, the higher forces are attained.

In the following, the magnitudes of the anisotropy energies will be compared with the energies of the reorientation E_{tw}, in different materials. As it was shown in Figure 2, energy densities E_{tw}, for producing strain of 1 percent in the selected martensitic shape memory alloys are between 10⁴ and 2.3 x 10⁵ J/m³. On the other hand, there is a diversity of materials available in which magnetic anisotropy energy densities are 10⁵ to 10⁸ J/m³. Some examples (Co-, Fe- and rare-earth-based alloys) were given above. Anisotropy energy densities of some materials are even four orders of magnitude larger than the energy densities E_{tw} for the reorientation of the twin structure, e.g., in In-TI. This large difference in energies Uₖ and E_{tw}, reveals that there is a great potential for finding optimal materials that combine high anisotropy energy and low E_{tw}.

In some ferromagnetic martensites twin boundaries are highly mobile under application of stress. It was shown in Figure 2 for the ferromagnetic martensitic Ni₂MnGa (single crystalline) that stresses as low as 10 to 20 MPa in direction [100] cause the reorientation of the twin variants, resulting in the recoverable strains of 4 percent. To reach a strain of 1 percent in this alloy by the magnetic-field-induced reorientation of the twin structure, anisotropy energy must be larger than the energy of the reorientation of the twin variants E_{tw}, 8.5 x 10⁴ J/m³, according to Figure 2. This value is quite low and, therefore, the magnetically induced strains are expected to be possible in this material. In most ferromagnetic shape memory alloys available to date and other iron-based alloys that exhibit a twinned substructure, stresses for aligning the twins are higher, even above 100 MPa. However, their magnetocrystalline anisotropy energies are often high enough for producing magnetic-field-induced strains based the reorientation of the twin structure, which has been experimentally demonstrated in some alloys. For example, in a material in which the stress of 100 MPa would be needed to reorient the twin structure producing a strain of 1 percent, E_{tw} is calculated to be 5 x 10⁵ J/m³ (assuming that stress increases linearly with strain). In order to produce the same strain by the magnetic-field-induced reorientation of the twin structure, anisotropy energy must be larger than or equal to 5 x 10⁵ J/m³. This anisotropy energy value is the same as that of cobalt and is attainable in many Fe- and Co-based alloys.

As a third example, let us assume that a very high stress of 500 Mpa would be needed to produce a strain of 1 percent by the reorientation of the twin structure in some materials. To produce the strain of the same amount by the magnetic field, anisotropy energy density of 2.5 x 10⁶ J/m³ is needed. This anisotropy energy value is attainable in suitable alloys, because the highest anisotropy energies at room temperature are even 20 times larger. It is emphasized that only estimations obtained from some material classes are used in this presentation for evaluating the magnetocrystalline anisotropy energies, because the anisotropy energy values for the twinned materials with low E_{tw} cannot be measured using saturation magnetization measurements (see Fig. 3). The reason is that the magnetization does not turn in the applied field to the hard direction of the unit cells, but the saturation is reached by turning the twin variants (together with the magnetization vectors) at lower magnetic field levels. The magnetization measurements should be made on single variant samples which are in many cases not possible to produce.

The development is focused in finding new ferromagnetic actuator materials which exhibit high anisotropy energy and low E_{tw}. The best materials may combine high anisotropy energies coming from the rare earth metals and highly glissile twin boundaries of a suitable twinned phase. Also Co- and Fe-based shape memory materials in which the martensitic lattice is close-packed hexagonal or cubic are promising and are being developed. The role of the interstitial atoms, especially nitrogen may be important, because they often increase the anisotropy energy and strengthen the alloy mechanically, which favors twinning as a deformation mechanism and prevents permanent slip. One interesting group of the magnetically controlled actuator materials are Heusler alloys (e.g., Ni₂MnGa-type) in which Mn is mainly responsible for their ferromagnetic properties.

The velocity of the twin boundaries in many materials is very fast, even a fraction of the speed of sound. This means that the magnetic-field-induced strokes are very fast in suitable actuator materials, and the actuators can operate at high frequencies.

### EXAMPLES

The reorientation of the twin structure by the magnetic field was experimentally studied in Fe-Ni-Co-Ti, Fe-Ni-C and Fe-Mn-N -based alloys. These materials are ferromagnetic and exhibit a twinned microstructure. The anisotropy energies were measured to be typically about 5 x 10⁵ J/m³ for Fe-Ni-Co-Ti alloys and 2 x 10⁵ J/m³ for Fe-Ni-C alloys. These are expected to be sufficiently high for producing the magnetic-field-induced strains based on the reorientation of the twin structure. The experimental setup employed in the present studies and examples of the measurements are shown in the following.

### The experimental setup

The principle of the actuator equipment for studying the effects of stress and magnetic field on the twin structure is shown in Figure 6. This actuator makes it possible to apply axial and torsional stresses on the actuating element (sample), and to measure the corresponding strains. The actuating element 6 was fixed in two coaxial supporting tubes 1 and 2. Tube 1 was fixed and tube 2 was used for straining the sample. The sample chamber was surrounded by a coil 7 for applying the magnetic field to the sample. In alternating magnetic field, a frequency response of the magnetically induced strains was measured at low frequencies. At higher frequencies, the frequency response was measured using a strain gauge attached on the sample. In these measurements bar 2 was removed. This arrangement was also used in experiments made on bent samples. The strain gauges were placed on both sides of the bent sample. The changes of strains caused by the applied magnetic field were measured in static and alternating magnetic fields.

Arrangements for measuring electrical resistivity and magnetic susceptibility were also made on the actuator, as shown in Figure 6, namely the four point contacts 3 for resistivity and the coils 5 for susceptibitity measurements. The sample chamber was immersed in liquid nitrogen or liquid helium, and the temperature could be controlled between 4 and 600 K using a heater 4.

Dissipation attributed to the motion of the twin boundaries and the martensite interfaces was also studied with this actuator. The amount of martensite and the twin structure was studied using electrical resistivity and magnetic susceptibility measurements. Also Mössbauer spectroscopy was used to determine the phase fraction of martensite. Mössbauer spectroscopy was more suitable for the present studies than X-ray diffraction, because Mössbauer measurements are not sensitive to the texture of the sample.

### EXAMPLE 1

An alternating twisting deformation was applied to the actuating element, and the vibration damping capacity was measured. These experiments revealed that twin boundaries (as well as the interfaces between austenite and the twinned martensite) were highly mobile. The measurements were made at strain amplitudes 10⁻⁶-10⁻³.

### EXAMPLE 2

Magnetically induced strains were measured on the bent actuating elements. In the beginning, the martensitic element was bent mechanically. During this deformation one side of the element was elongated and the other side was contracted. As a result, the twin structures on different sides of the elements were oriented in different ways, leading to the different proportions of twin variants, to accommodate compressive and tensile stresses. It was confirmed that the amount of martensite was substantially the same on both sides of the element. When the magnetic field was applied to the bent element, the field-induced strains appeared, and they were in opposite directions on different sides of the element. On the side which was initially elongated by the mechanical stress, the magnetic field induced a contraction and on the other side the field induced an elongation. For example, when a magnetic field of 1 kOe was applied on a slightly bent twinned martensitic Fe-Ni-C sample of 1 mm in thickness, the difference in strains between the two sides was 2.2 x 10⁻⁵. This value is higher than magnetostriction of this material. Magnetostriction cannot be the explanation for this effect, because it cannot cause strains of the opposite directions in different sides of the element, and secondly because its magnitude is too small.

The initial mechanical deformation was also made by twisting. The twisting deformation results in a specific reorientation of the twin structure. When the magnetic field was applied on this structure, the torsional strains appeared. The magnetically induced strains observed on the bent and twisted actuating elements could be attributed to the reorientation of the twin structure or the growth of the preferentially oriented martensite. The present experiments were made, however, above M_{d} temperatures of the martensite. At temperatures above M_{d}, the formation of martensite is not thermodynamically possible, which confirms that the magnetically controlled reorientation of the twin structure causes the strains observed.

The bending and twisting experiments also suggest that more complicated shape changes can be produced using external magnetic field.

### EXAMPLE 3

X-ray diffraction patterns of martensite were measured in magnetic fields perpendicular to and parallel to the surface of the actuating element. The intensities of the individual Bragg peaks correlate with the fraction of the twin variants in the diffraction condition. The measurements showed changes in peak intensities which were attributed to the magnetically induced twin reorientation of the martensite. The peak intensities were observed to change also in alloys in which only the inner parts of martensite plates are twinned. The outer parts of the plates consist of dislocation cells and tangles. Therefore, the interfaces between the martensite and austenite phases are immobile in those alloys, and the magnetic-field-controlled growth of the martensite plates with preferentially oriented twin variants cannot serve as an explanation for the effects observed.

### INDUSTRIAL APPLICABILITY

The new actuators based on the present invention exhibit a great technological and commercial potential. No other method for producing motion and force based on the material properties can develop such a combination of high strains, forces, speed and precision as these new actuators. Potential applications are gas and hydaulic valves, fuel injectors, high-pressure pumps, actuators of active vibration control, active springs, valve lifters and controllers, robots, precision tooling and linear motors. Operation of the linear motors is based on the synchronous operation of several actuators. One actuator is responsible for the linear motion and two other actuators clamp in turns on the guide along which the linear motor travels. The actuators according to the invention can also be used in positioning and transporting devices in which the step of each motion is produced by the actuators according to the invention. One example of high frequency applications of the present actuators are ultrasonic vibrators, e.g., washers.

Actuators can also be integrated with sensing and control capabilities. Those systems, named adaptive, active or smart structures, are becoming general in modem machine design. Sensing the operational parameters of a machine in real time, and responding to the environmental or internal changes in a controlled manner makes it possible to attain more optimal operation, minimal energy consumption, enhanced life-times of the structures and lower maintenance costs. Adaptive structures are applied in aerospace, automotive, marine and civil engineering, precision machining and production engineering. Active vibration control is an example of a smart structure. Vibration of a machine is detected by acceleration or displacement sensors. The actuators according to the invention are used to generate countervibrations and forces that cancel the original vibration.

The most widely used actuators are pneumatic and hydraulic systems, electromagnetic drives and actuators based on such materials as piezoelectrics, magnetostrictive materials and shape memory alloys. Progress of the adaptive structures has been severely retarded by the absence of the high speed and large stroke actuator materials. The new actuators according to the present invention may lead to a great advance in the technology of the adaptive structures and modern engineering.

Because the reorientation of the twin structure occurs in three dimensions, complex shape changes including tension, bending and twisting of the samples can be produced by the magnetic field. This significantly expands the applicability of the present invention in many fields of engineering and machinery. Other magnetically driven actuators based on magnetostriction do not have such properties. The actuator/machine developing a controlled motion or certain shape changes by the magnetic field may be an appropriately shaped and preoriented piece of material. By designing the shape and the initial twin structure properly, the actuator can repeat complex shape changes when the intensity of the magnetic field is cycled. The trace of the motion of the actuator can be changed by changing the direction of the field.

The method of the present invention makes it possible to control the operation of the actuators remotely. Remote control is suitable, for example, in biomedical applications like in medical instruments, artificial organs, such as a heart. A large number of actuators could operate simultaneously using a common magnetic-field-control. Even if the magnetic field were the same for all of the actuators, the actuators could be made to operate in different ways depending on the initial twin structure made in the material.

Because the twin structure is expected to be controlled also in thin films, wires and particles, the actuators based on this invention may also be applied in micro and nanotechnology. The actuators could be even the size of the individual twins. The nanoactuators could utilize, e.g., quantum tunneling currents for the position sensing.

The present invention is a new class of actuators that produce motion, force and shape changes using electric energy. Those actuators may exhibit a potential to become the most widely used electric drives after motors and other devices based on electromagnetic forces. In several fields of engineering, the new actuators are expected to replace the conventional electric devices due to their better performance, greater reliability and lower costs. The largest potential of the present invention may lie, however, in new applications which only the technology based on this invention makes possible.

Selected examples of the applications of the actuators according to the invention are presented as follows. Those examples are not regarded as limiting.

### Application example 1

Actuators according to the invention can be used to produce motion and force in the fuel injectors and pumps, e.g., in diesel, gasoline or jet engines due to their high speed and force and large precisely controlled strokes. Fast and precise control of the fuel injection makes it possible to inject fuel in rapid bursts that exhibit controlled time-dependent profiles. The control of the fuel injection is possible even during the burning process of the fuel. The injection can be feed-back controlled according to the information of temperature, pressure and contents of different gases, e.g., exhaust gases, of the burning chamber. Actuators according to the invention can control the fuel flow in the injector or even pump the fuel. In the latter case, no separate injector is needed because the pump itself can control the volumes of the injected fuel. For instance, in piston-type engines each cylinder may have one or more such pumps. The pumps and injectors can also inject other liquids, e.g., water, in the burning chamber.

The actuators according to the invention may also be used to produce motion and force in the suck and exhaust valve lifters of the engines. Opening and closing of the valves are controlled in real time based on the information obtained from the sensors in the same way as in the case of injectors. The controlled injection and valves optimizes the burning process, decreases fuel consumption and produces less harmful exhaust gases. It also improves the efficiency and power output of the engine and reduces the moving parts of the engine.

### Application example 2

The actuators according to the invention are used to produce displacements and forces in the testing machines of materials and structures, e.g., in fatique testing machines. Testing machines based on the present actuators are faster and more compact and smaller than servohydraulic machines. Fast response of the present actuators makes it possible to perform testing at high frequencies and also to run complicated testing profiles that simulate real environmental or machine vibrations. Because of the small size and portability of the testing machines based on the present actuators, these testing machines can be placed in the test surroundings rather than simulating the testing conditions in the sample chamber of the servohydraulic machines.

### Application example 3

The actuators according to the invention are used to move tools in the machine tools, e.g., in the turning, milling, shaping and grinding machines. The actuator can be feed-back controlled according to information of the position or shape of the body to be machined or distance between the tool and the body. Due to fast and precise response of the present actuators, it is possible to machine complicated shapes and compensate vibrations and dimensional errors of the body. For instance in a turning machine, bodies with oval and irregular cross sections can be lathed, and the surface quality is excellent because of the compensation of the vibrations.

## Claims

1. An actuator including an actuating element for producing motion and/or force, whereby the element comprises material having a twinned structure, the proportions of the twin variants being able to be changed with a magnetic field, induced by at least one source of a magnetic field, of the direction and magnitude enough for the changing the proportions of the twin variants and producing thereby shape changes of the material and motion and/or force.

2. An actuator according to claim 1 including an actuating element wherein the change of the proportions of the twin variants includes the reorientation of the twin variants in one phase and/or the change of the proportions of the twin variants in the martensite plates due to the change of the dimensions of the plates.

3. An actuator according to claim 1 or 2, having two sources of magnetic field generating magnetic field components so that the resulting magnetic field is rotating in relation to the actuating element thereby producing periodically alternating shape changes of the element.

4. An actuator according to claim 1 or 2, wherein the magnetic field is designed to produce a desired shape change, e.g., axial strain, bending, shearing or twisting of the actuating material.

5. An actuator according to claim 1 or 2, having at least one loading device intended to work against the force induced by the magnetic field and/or to restore the shape change induced by the magnetic field.

6. An actuator according to claim 1 or 2, wherein a magnetic field source is designed to produce a magnetic field in the direction of the easy magnetization of a selected twin variant of the actuating element.

7. An actuator according to claim 1 or 2, wherein a magnetic field source is designed to produce a magnetic field in the direction different from the easy magnetization of the twin variants of the actuating element.

8. An actuator according to claim 1 or 2, wherein the magnetocrystalline anisotropy energy of the material of the actuating element is higher than or comparable to the sum of the energies of the reorientation of the twin structure required to produce a desired shape change and the work done by the material.

9. An actuator according to claim 1 or 2, wherein the energy of the magnetic field applied on the material is higher than or comparable to the sum of the energies of the reorientation of the twin structure required to produce a certain shape change and the work of the material.

10. An actuator according to claim 1 or 2, wherein the direction of the magnetic field is the direction of the easy magnetization of a selected twin orientation.

11. An actuator according to claim 1 or 2, wherein the magnetic field is substantially parallel to the direction of the long dimension of the actuating element.

12. An actuator according to claim 1 or 2, wherein the magnetic field is substantially perpendicular to the direction of the long dimension of the actuating element.

13. An actuator according to claim 1 or 2, having two sources of a magnetic field, the magnetic fields induced by the same being substantially parallel to each other, whereby one or both of the fields can be static.

14. An actuator according to claim 1 or 2, wherein the material of the actuating element is ferromagnetic.

15. An actuator according to claim 1 or 2, wherein the material of the actuating element is martensite.

16. An actuator according to claim 1 or 2, wherein the material of the actuating element is a Heusler alloy, such as Ni-Mn-Ga.

17. An actuator according to claim 1 or 2, wherein the material of the actuating element is an Fe- or Co-based alloy with cubic or hexagonal crystal structure.

18. An actuator according to any of the preceding claims, wherein the actuators are made from twinned thin films, wires or particles.

19. An actuator according to any of the preceding claims, wherein the actuator is designed to form part of a pump, injector or similar device for transferring material, especially fluid.

20. An actuator according to any of the preceding claims, wherein the actuator is designed to form part of a valve controller of the engine.

21. An actuator according to any of the preceding claims, wherein the actuator is designed to form part of a device for testing materials and structures.

22. An actuator according to any of the preceding claims, wherein the actuator is designed to form part of precise tooling, positioning device, a device for producing relative movement, like a transport device, linear motor or robot device.

23. An actuator according to any of the preceding claims, wherein the actuator is designed to form part of an ultrasonic vibrator, e.g., washer, micro actuator or the like device.

24. An actuator according any of the preceding claims, wherein magnetic field is variable in respect of its direction and/or magnitude.

25. An actuator according to any of the preceding claims, having a device for monitoring or for sensoring the state of the shape of the actuating element.

## Patentansprüche

1. Aktuator, umfassend ein Betätigungselement zum Erzeugen von Bewegung und/oder Kraft, wobei das Element Material mit einer Zwillingsstruktur umfasst, wobei die Dimensionen der Zwillingsvarianten mit einem magnetischen Feld verändert werden können, welches durch wenigstens eine Quelle für ein Magnetfeld induziert wird und eine Richtung und ausreichende Stärke, um die Dimensionen der Zwillingsvarianten zu verändern und dadurch Formveränderungen des Materials und der Bewegung und/oder Kraft zu erzeugen.

2. Aktuator nach Anspruch 1, umfassend ein Betätigungselement, wobei die Veränderung der Dimensionen der Zwillingsvarianten die Umorientierung der Zwillingsvarianten in einer Phase und/oder die Veränderung der Dimensionen der Zwillingsvarianten in den Martensitplatten auf Grund der Veränderung der Abmessungen der Platten umfasst.

3. Aktuator nach Anspruch 1 oder 2, das zwei Quellen von ein Magnetfeld erzeugenden Magnetfeldbauteilen aufweist, so dass das sich ergebende Magnetfeld sich in Bezug auf das Betätigungselement dreht, wodurch sich periodisch abwechselnde Formveränderungen des Elements erzeugt werden.

4. Aktuator nach Anspruch 1 oder 2, wobei das Magnetfeld so gestaltet ist, dass eine gewünschte Formveränderung, z.B. eine axiale Belastung, ein Biegen, ein Scheren oder ein Verwinden, des Betätigungsmaterials erzeugt wird.

5. Aktuator nach Anspruch 1 oder 2, das wenigstens eine bewegte Vorrichtung aufweist, die gegen die Kraft, die durch das Magnetfeld induziert wird, arbeiten und/oder die Formveränderung, die durch das Magnetfeld induziert wird, wieder rückgängig machen soll.

6. Aktuator nach Anspruch 1 oder 2, wobei eine Magnetfeldquelle so gestaltet ist, dass ein Magnetfeld in der Richtung der sich leicht einstellenden Magnetisierung einer ausgewählten Zwillingsvariante des Betätigungselements erzeugt wird.

7. Aktuator nach Anspruch 1 oder 2, wobei eine Magnetfeldquelle so gestaltet ist, dass ein Magnetfeld in der Richtung erzeugt wird, die sich von der sich leicht einstellenden Magnetisierung der Zwillingsvarianten des Betätigungselements unterscheidet.

8. Aktuator nach Anspruch 1 oder 2, wobei die magnetokristalline Anisotropie-Energie des Materials des Betätigungselements größer als oder vergleichbar mit der Summe der Energien der Umorientierung der Zwillingsstruktur ist, die erforderlich ist, um eine gewünschte Formänderung und die Arbeit zu erzeugen, die durch das Material verrichtet wird.

9. Aktuator nach Anspruch 1 oder 2, wobei die Energie des Magnetfeldes, das auf das Material angelegt wird, größer als oder vergleichbar mit der Summe der Energien der Umorientierung der Zwillingsstruktur ist, die erforderlich ist, um eine gewünschte Formänderung und die Arbeit des Materials zu erzeugen.

10. Aktuator nach Anspruch 1 oder 2, wobei die Richtung des Magnetfeldes die Richtung der sich leicht einstellenden Magnetisierung einer ausgewählten Zwillingsorientierung ist.

11. Aktuator nach Anspruch 1 oder 2, wobei das Magnetfeld im Wesentlichen parallel zur Richtung der Längsabmessung des Betätigungselements liegt.

12. Aktuator nach Anspruch 1 oder 2, wobei das Magnetfeld im Wesentlichen senkrecht zur Richtung der Längsabmessung des Betätigungselements liegt.

13. Aktuator nach Anspruch 1 oder 2, welches zwei Quellen eines Magnetfeldes aufweist, wobei die Magnetfelder, die durch selbige induziert werden, im Wesentlichen parallel zueinander liegen, wobei eines oder beide Felder statisch sein können.

14. Aktuator nach Anspruch 1 oder 2, wobei das Material des Betätigungselements ferromagnetisch ist.

15. Aktuator nach Anspruch 1 oder 2, wobei das Material des Betätigungselements Martensit ist.

16. Aktuator nach Anspruch 1 oder 2, wobei das Material des Betätigungselements eine Heusler-Legierung wie Ni-Mn-Ga ist.

17. Aktuator nach Anspruch 1 oder 2, wobei das Material des Betätigungselements eine Legierung auf Fe- oder Co-Basis mit kubischer oder hexagonaler Kristallstruktur ist.

18. Aktuator nach jedem der vorangehenden Ansprüche, wobei die Aktuatoren aus Zwillingsdünnfilmen, -drähten oder -partikeln hergestellt sind.

19. Aktuator nach jedem der vorangehenden Ansprüche, wobei der Aktuator so gestaltet ist, dass es einen Teil einer Pumpe, eines Injektors oder einer ähnlichen Vorrichtung zum Übertragen von Material, insbesondere Fluid, bildet.

20. Aktuator nach jedem der vorangehenden Ansprüche, wobei der Aktuator so gestaltet ist, dass es einen Teil einer Ventilsteuerung des Motors bildet.

21. Aktuator nach jedem der vorangehenden Ansprüche, wobei der Aktuator so gestaltet ist, dass es einen Teil einer Vorrichtung zum Prüfen von Materialien und Strukturen bildet.

22. Aktuator nach jedem der vorangehenden Ansprüche, wobei der Aktuator so gestaltet ist, dass es einen Teil einer Präzisionswerkzeug-Positionierungsvorrichtung, einer Vorrichtung zum Erzeugen relativer Bewegung wie einer Fördervorrichtung, eines Linearmotors oder einer Robotervorrichtung bildet.

23. Aktuator nach jedem der vorangehenden Ansprüche, wobei der Aktuator so gestaltet ist, dass es einen Teil eines Ultraschallvibrators, z.B. eine Waschanlagen-, einen Mikroaktuator- oder eine ähnliche Vorrichtung, bildet.

24. Aktuator nach jedem der vorangehenden Ansprüche, wobei das Magnetfeld in Bezug auf seine Richtung und/oder Stärke variabel ist.

25. Aktuator nach jedem der vorangehenden Ansprüche, welches eine Vorrichtung zum Überwachen oder zum Erfassen des Zustands der Form des Betätigungselements aufweist.

## Revendications

1. Actionneur comprenant un élément actionneur pour produire du mouvement et/ou des forces, de façon que l'élément comprend un matériau présentant une structure maclée, de manière que les proportions des variantes de macles puissent être changées avec un champ magnétique induit au moins par une source de champ magnétique, qui a une direction et une amplitude suffisantes pour changer les proportions des variantes de macles afin de produire ainsi des changements de forme, de mouvement et/ou de force du matériau.

2. Actionneur selon la revendication 1, comprenant un élément actionneur, dans lequel le changement de proportions des variantes de macles inclut la réorientation des variantes de macles en une phase et/ou le changement de proportions des variantes de macles dans les plaques de martensite par suite du changement des dimensions des plaques.

3. Actionneur selon la revendication 1 ou 2, comportant deux sources de champ magnétique générant des composants du champ magnétique si bien que le champ magnétique qui en résulte tourne par rapport à l'élément actionneur, produisant ainsi des changements de forme périodiquement alternants de l'élément.

4. Actionneur selon la revendication 1 ou 2, dans lequel le champ magnétique est conçu pour produire un changement de forme désiré, par exemple la déformation, la flexion, le cisaillement ou la torsion du matériau actionneur.

5. Actionneur selon la revendication 1 ou 2, comportant au moins un dispositif de chargement dont le but est de travailler contre la force induite par le champ magnétique et/ou de reconstituer le changement de forme induit par le champ magnétique.

6. Actionneur selon la revendication 1 ou 2, dans lequel une source de champ magnétique est conçue pour produire un champ magnétique dans la direction de la magnétisation aisée d'une variante de macle choisie de l'élément actionneur.

7. Actionneur selon la revendication 1 ou 2, dans lequel une source de champ magnétique est conçue pour produire un champ magnétique dans la direction différant de la direction de magnétisation aisée des variantes de macles de l'élément actionneur.

8. Actionneur selon la revendication 1 ou 2, dans lequel l'énergie d'anisotropie magnétocristalline du matériau de l'élément actionneur est supérieure ou comparable à la somme des énergies de réorientation de la structure maclée requises pour produire un changement de forme désiré et le travail effectué par le matériau.

9. Actionneur selon la revendication 1 ou 2, dans lequel l'énergie du champ magnétique appliqué au matériau est supérieure ou comparable à la somme des énergies de réorientation de la structure maclée requises pour produire un certain changement de forme et le travail du matériau.

10. Actionneur selon la revendication 1 ou 2, dans lequel la direction du champ magnétique est la direction de la magnétisation aisée de l'orientation de macle choisie.

11. Actionneur selon la revendication 1 ou 2, dans lequel le champ magnétique est sensiblement parallèle à la direction de la dimension longue de l'élément actionneur.

12. Actionneur selon la revendication 1 ou 2, dans lequel le champ magnétique est sensiblement perpendiculaire à la direction de la dimension longue de l'élément actionneur.

13. Actionneur selon la revendication 1 ou 2, comportant deux sources de champ magnétique, les champs magnétiques induits pas les mêmes étant sensiblement parallèles l'un à l'autre, de manière que l'un ou les deux des champs puissent être statiques.

14. Actionneur selon la revendication 1 ou 2, dans lequel le matériau de l'élément actionneur est ferromagnétique.

15. Actionneur selon la revendication 1 ou 2, dans lequel le matériau de l'élément actionneur est martensitique.

16. Actionneur selon la revendication 1 ou 2, dans lequel le matériau de l'élément actionneur est un alliage Heusler tel que Ni-Mn-Ga.

17. Actionneur selon la revendication 1 ou 2, dans lequel le matériau de l'élément actionneur est un alliage à base de Fe ou de Co avec une structure cristalline cubique ou hexagonale.

18. Actionneur selon l'une quelconque des revendications précédentes, dans laquelle les actionneurs sont faits de films minces, fils ou particules maclés.

19. Actionneur selon l'une quelconque des revendications précédentes, dans laquelle l'actionneur est conçu pour constituer une partie d'une pompe, d'un injecteur ou d'un dispositif similaire afin de transférer un matériau, en particulier un fluide.

20. Actionneur selon l'une quelconque des revendications précédentes, dans laquelle l'actionneur est conçu pour constituer une partie d'un contrôleur de soupape du moteur.

21. Actionneur selon l'une quelconque des revendications précédentes, dans laquelle l'actionneur est conçu pour constituer une partie d'un dispositif pour tester des matériaux et des structures.

22. Actionneur selon l'une quelconque des revendications précédentes, dans laquelle l'actionneur est conçu pour constituer une partie d'un outillage précis, d'un dispositif de positionnement, d'un dispositif pour produire un mouvement relatif tel qu'un dispositif de transport, un moteur linéaire ou un dispositif robotisé.

23. Actionneur selon l'une quelconque des revendications précédentes, dans laquelle l'actionneur est conçu pour constituer une partie d'un vibreur à ultrasons, par exemple un dispositif de lavage, un micro-actionneur ou un dispositif similaire.

24. Actionneur selon l'une quelconque des revendications précédentes, dans laquelle un champ magnétique est variable par rapport à sa direction et/ou son amplitude.

25. Actionneur selon l'une quelconque des revendications précédentes, comprenant un dispositif pour surveiller ou pour détecter l'état de la forme de l'élément actionneur.
